# EUROPEAN PATENT APPLICATION

(11) **EP 1 912 286 A1**
(43) Date of publication of application: **16.04.2008**
(21) Application number: 06757212.3
(22) Date of filing: 09.06.2006
(51) Int. Cl.: H01R 11/01, H01R 43/00, H05K 1/02, H05K 1/11

(54) **COMPOSITE POROUS RESIN BASE MATERIAL AND METHOD FOR MANUFACTURING SAME**

(30) Priority: 19.07.2005 JP 2005208286
(71) Applicant: Sumitomo Electric Industries, Ltd., Osaka-shi, Osaka 541-0041 (JP)
(72) Inventor: IDOMOTO, Yuichi, c/o SUMITOMO ELEC. IND., LTD., Osaka-shi, Osaka 554-8511 (JP); OKUDA, Yasuhiro, c/o SUMITOMO ELEC. IND., LTD., Osaka-shi, Osaka 554-8511 (JP)
(74) Representative: Cross, Rupert Edward Blount
(86) International application number: PCT/JP2006/311589
(87) International publication number: WO 2007/010684

(57) **Abstract**

In a composite porous resin base material (1), a porous resin film (2) is provided with a functional section (3) whereupon an electrode (4) and/or a circuit is formed. On the periphery surrounding the functional section (3), a step (5) having a height different from that of the functional section (3) is formed, and a frame plate (6) is arranged on a plane of the step (5). Provided is the composite porous resin base material which has a structure wherein the frame plate having rigidity is attached to the porous resin base material whereupon the electrode and/or a circuit is formed without deteriorating characteristics such as elasticity and conductivity of the porous resin base material.

## Description

### TECHNICAL FIELD

The present invention relates to a composite porous resin base material obtained by compositing a porous resin base material provided with an electrode and/or a circuit and a frame plate with each other. The composite porous resin base material according to the present invention can be preferably employed for application to various connectors or interposers such as anisotropic conductive films employed for electrically connecting two circuit devices with each other or anisotropic conductive films employed for an electrical test of a circuit device such as a semiconductor integrated circuit device (semiconductor chip, for example) or a printed circuit board, for example. In the present invention, it is assumed that "an electrode and/or a circuit" denotes an electrode or a circuit, or an electrode and a circuit.

### BACKGROUND ART

Japanese Patent Laying-Open No. 2004-265844 (Patent Document 1) discloses a method for forming conductive portions by employing an electrical insulating porous resin film as a base film, providing a plurality of through-holes passing through a first surface and a second surface in the thickness direction on a plurality of portions of the base film and thereafter bonding conductive metal to resin portions on the inner wall surfaces of the respective through-holes.

According to the method described in Patent Document 1, an anisotropic conductive film having a plurality of conductive portions formed in the thickness direction of a porous resin film can be obtained. In other words, the conductive portions are independently provided in the matrix of the electric insulating porous resin film respectively and conductive in the thickness direction, while these conductive portions do not conduct or short-circuit to each other.

The conductive portions, formed by bonding the conductive metal to the resin portions constituting a porous structure on the inner wall surfaces of the through-holes by electroless plating or the like, can be referred to as "cylindrical electrodes" from the shape thereof. The conductivity of the cylindrical electrodes in the thickness direction can be controlled by adjusting the quantity of the bonded conductive metal. In general, a load is applied to the porous resin base material in the thickness direction for compressing overall porous resin base material including the cylindrical electrodes, thereby allowing the same to conduct.

This anisotropic conductive film is elastic in the thickness direction, and capable of conducting in the thickness direction with a low compression load. Further, the size, the pitch etc. of the conductive portions can be fined in this anisotropic conductive film. The anisotropic conductive film can obtain electric conduction in the thickness direction with a low compression load as an anisotropic conductive film for testing a semiconductor integrated circuit device or the like, for example, while the thickness thereof is recovered due to the elasticity even if a load is repetitively applied thereto, so that the film can be repetitively used for the test.

In order to electrically test a circuit device such as a semiconductor integrated circuit device (semiconductor chip, for example) or a printed circuit board, electrodes of the circuit device and those of a testing device (a checker or a tester) must be correctly connected in correspondence to each other. However, the electrodes of the testing device are arranged on a rigid substrate, and hence it is difficult to correctly connect the electrodes of the circuit device and those of the testing device in correspondence to each other, or the electrodes are easily damaged by contact therebetween.

Therefore, a method for electrically connecting the electrodes with each other through an elastic anisotropic conductive film by interposing the anisotropic conductive film between an electrode region of the circuit device and that of the testing device is employed. The anisotropic conductive film is provided with a plurality of conducting portions conductible only in the thickness direction. These conducting portions are also referred to as conductive portions or electrodes. As the electrode pitch of the circuit device is fined, the pitch of the conducting portions of the anisotropic conductive film is fined, or a pitch conversion board is additionally arranged on the circuit device while interposing the anisotropic conductive film.

In order to use a porous resin base material provided with the aforementioned conducting portions as an anisotropic conductive film for electrically testing a circuit device, the positional relation of the porous resin base material must be so set and fixed that the electrodes of the circuit device and those of the testing device are correctly electrically connected with each other. Pinning is simple as a method for fixing the porous resin base material. Therefore, a plurality of pinholes are provided on the periphery of the porous resin base material, for fixing the porous resin base material to a prescribed portion of the testing device with pins through the pinholes.

When arranged between a semiconductor integrated circuit device (semiconductor chip, for example) and a circuit board such as a printed circuit board, the said porous resin base material can serve as a kind of connector or interposer having a stress relaxation function and a conducting function. Also in this case, the porous resin base material is preferably fixed to a prescribed position by pinning.

However, the base film of the porous resin base material is formed by the porous resin film rich in flexibility, whereby the porous resin base material may be deformed or broken from around the pinholes if the same is simply pinned, such that the initially fixed position cannot be maintained. In order to solve this problem, a method of mounting a rigid flame plate on the periphery of the porous resin base material is conceivable. The frame plate is formed by a metal plate or the like having an opening, and the conducting portions of the porous resin base material are arranged in the opening. When holes for pinning are formed in the portion provided with the flame plate for fixing the porous resin base material to the circuit device by passing pins through the holes, the porous resin base material can be prevented from deformation or breakage.

If the rigid frame plate is mounted on a single surface or each surface of the porous resin base material, however, the porous resin base material is so inhibited from compression in the thickness direction that it is difficult to allow the conducting portions to conduct with a low compression load. Further, the elasticity of the overall porous resin base material is damaged by the rigid frame plate. In addition, the frame plate inhibits electrodes and/or circuits of the porous resin base material from coming into contact with electrodes or circuits of the circuit device or the testing device.

In general, a method for holding/fixing an anisotropic conductive sheet on/to an electric circuit component with specific positional relation by arranging a frame plate is proposed in the technical field of the anisotropic conductive sheet (anisotropic conductive film) having a base film of a rubber-like elastic body.

For example, Japanese Patent Laying-Open No. 11-40224 (Patent Document 2) proposes an anisotropic conductive sheet (anisotropic conductive elastomer sheet) obtained by arranging a metal plate on the periphery of an anisotropic conductive sheet having a base film of a rubber-like elastic body as a frame plate. In order to prepare this anisotropic conductive sheet, a molding material layer is first formed by arranging a frame plate having an opening in a molding die assembly while supplying a polymer forming material containing conductive particles exhibiting magnetism. The periphery of the molding material layer is supplied up to a region including upper and lower portions of the opening edge of the frame plate. A plurality of ferromagnetic layers and a plurality of magnetized layers are alternately formed on upper and lower mold sections of the die assembly respectively. When a magnetic field is applied through an electromagnet, the conductive particles exhibiting magnetism gather between the opposed ferromagnetic layers of the upper and lower mold sections, and so orient as to line up in the thickness direction. When the polymer forming material is cured in this state, an elastic polymer sheet (anisotropic conductive sheet) provided with a plurality of conductive portions consisting of the conductive particles orienting in the thickness direction is obtained.

When the method disclosed in Patent Document 2 is employed, an anisotropic conductive sheet having such a structure that the opening edge of the frame plate is embedded in the periphery of the elastic polymer sheet can be obtained. According to this method, a frame plate having a smaller thickness than the elastic polymer sheet can be mounted, whereby the frame plate neither damages the elasticity of the elastic polymer sheet nor inhibits the conductive portions from conduction.

In the method described in Patent Document 2, however, conductive particles having been present on portions located above and below the frame plate also gather to conductive portion forming regions around the frame plate, whereby the conductive particles so excessively gather on the conductive portion forming regions that the conductive portions formed of such conductive portion forming regions cannot be insulated from other conductive portions adjacent thereto.

Japanese Patent Laying-Open No. 2002-324600 (Patent Document 3) proposes a method using a frame plate constituted of a magnetic body for fixing conductive particles present on portions located above and below the frame plate to an opening edge of the frame plate thereby preventing these particles from gathering on conductive portion forming regions around the frame plate, in order to solve the aforementioned problem of the method described in Patent Document 2.

However, the technique of mounting the frame plate in the anisotropic conductive elastomer sheet disclosed in each of Patent Documents 2 and 3 cannot be applied to an anisotropic conductive film having a base film formed by a porous resin film. The polymer forming material disclosed in each of Patent Documents 2 and 3, exhibiting fluidity in an uncured state, is converted to an elastic film (elastic polymer sheet) when cured. In order to mount a frame plate on such an elastic polymer sheet, the polymer forming material must be integrally molded with the frame in the state having fluidity. When the opening edge of the frame plate is embedded in the periphery of the polymer sheet to be integrated therewith after curing, the elastic polymer sheet is deformed due to stress. In other words, if the opening edge of the frame plate is pushed into the periphery of the elastic polymer sheet, the pressed portion of the elastic polymer escapes toward another portion, to deform the sheet. According to the method disclosed in Patent Document 3, further, the material for the frame plate is limited.

An anisotropic conductive film having a base film formed of a porous resin film is generally provided with electrodes and/or circuits after formation of the porous resin film. The porous resin film is generally rendered porous by drawing a resin material, and hence it is difficult to prepare a composite having such a structure that an opening edge of a frame plate is embedded in the periphery of a porous resin film in formation of the porous resin film. When the opening edge of the frame plate is embedded in the periphery of an already formed porous resin film, on the other hand, the porous resin film is deformed or broken.
Patent Document 1: Japanese Patent Laying-Open No. 2004-265844
Patent Document 2: Japanese Patent Laying-Open No. 11-40224
Patent Document 3: Japanese Patent Laying-Open No. 2002-324600

### DISCLOSURE OF THE INVENTION

### PROBLEMS TO BE SOLVED BY THE INVENTION

An object of the present invention is to provide a composite porous resin base material having a structure obtained by mounting a rigid frame plate on a porous resin base material provided with an electrode and/or a circuit without damaging properties such as elasticity and conductivity of the porous resin base material.

The inventors have made deep studies in order to solve the aforementioned problems, to reach a method of forming a step having a height different from the height of a functional section on the periphery, surrounding the functional section, of a porous resin base material having the functional section provided with an electrode and/or a circuit and arranging a frame plate on the surface of the step. Preferably, a step having a height smaller than the height of the functional section is formed and a frame plate having a thickness smaller than the height of the step is arranged on the surface of the step.

In order to form the step on the porous resin base material, hot pressing can be employed, for example. On the porous resin base material, the step can be easily formed by hot pressing, dissimilarly to an anisotropic conductive elastomer sheet having a base film formed by an elastomer sheet. When the periphery of the anisotropic conductive elastomer sheet is hot-pressed, the elastomer present in the periphery moves to the central section, whereby the functional section easily fluctuates in thickness or is easily deformed. On the other hand, the porous resin base material neither changes the thickness of the functional section provided with the electrode and/or the circuit nor deforms the same through formation of the step by hot pressing, although the porous structure of the hot-pressed portion is densified. Further, a step having a desired level difference and a desired shape can be provided by controlling the hot pressing condition.

While the frame plate is arranged on the aforementioned step of the porous resin base material, the thickness of the frame plate is preferably rendered smaller than the height of the step. The thickness of the frame plate is so rendered smaller than the height of the step that the upper surface of the functional section is positioned above the upper surface of the frame plate, whereby elasticity and conductivity in the functional section are not damaged. The functional section provided with the electrode and/or the circuit so upwardly protrudes that contact between the electrode and/or the circuit of the functional section and an electrode or a circuit of a circuit device or a testing device is not inhibited.

According to the present invention, an arbitrary frame plate prepared from a metallic material or a resin material having higher rigidity as compared with the porous resin film forming the base film of the porous resin base material can be employed. When a hole for pinning is provided on a desired portion where the frame plate is present to pass through the frame plate and the porous resin base material after the arrangement of the frame plate and the porous resin base material is pinned to an electrode region of the circuit device or the testing device through the hole, the porous resin base material can be fixed and held in prescribed positional relation.

The functional section provided with the electrode and/or the circuit may be formed after the arrangement of the frame plate. In other words, the electrode and/or the circuit may be provided on a portion (central section) of the porous resin film located in an opening of the frame plate after the step is formed on the periphery of the porous resin film and the frame plate is arranged on the step. Alternatively, the frame plate may be arranged on the step after the step is formed on the periphery of the porous resin film and the electrode and/or the circuit is formed on the portion (central section) of the porous resin film located in the opening of the frame plate. The present invention has been completed on the basis of these recognitions.

### MEANS FOR SOLVING THE PROBLEMS

According to the present invention, a composite porous resin base material comprising a porous resin film having a functional section provided with an electrode and/or a circuit, a step, having a height different from the height of the functional section, formed on the periphery surrounding the functional section and a frame plate arranged on the surface of the step is provided.

According to the present invention, a method for manufacturing a composite porous resin base material, including the following steps 1 and 2:
(1) the step 1 of forming a step having a height smaller than the height of a functional section on the periphery surrounding the functional section of a porous resin base material having the functional section provided with an electrode and/or a circuit; and
(2) the step 2 of arranging a frame plate having a thickness smaller than the height of the step on the surface of the step;
is provided.

According to the present invention, further, a method for manufacturing a composite porous resin base material, including the following steps A to C:
(A) the step A of forming a step having a height smaller than the height of a central section on the periphery surrounding the central section of a porous resin film;
(B) the step B of arranging a frame plate having a thickness smaller than the height of the step on the surface of the step; and
(C) the step C of forming an electrode and/or a circuit on the said central section of the porous resin film;
is provided.

According to the present invention, further, a method for manufacturing a composite porous resin base material, including the following steps I to III:
(I) the step I of forming a step having a height smaller than the height of a central section on the periphery surrounding the central section of a porous resin film;
(II) the step II of forming an electrode and/or a circuit on the said central section of the porous resin film; and
(III) the step III of arranging a frame plate having a thickness smaller than the height of the step on the surface of the step;
is proposed.

### EFFECTS OF THE INVENTION

According to the present invention, a composite porous resin base material having a structure obtained by mounting a rigid frame plate on a porous resin base material provided with an electrode and/or a circuit without damaging properties such as elasticity and conductivity of the porous resin base material is provided. The porous resin base material can be prevented from displacement and breakage, due to the arrangement of the frame plate.

The composite porous resin base material according to the present invention is obtained by arranging the frame plate having a small thickness on the step provided on the periphery of the porous resin film, not to damage the elasticity and conduction in the functional section provided with the electrode and/or the circuit. When the functional section provided with the electrode and/or the circuit is made to protrude, contact between the electrode and/or the circuit of the functional section and an electrode and/or a circuit of a circuit device or a testing device is not inhibited.

### BRIEF DESCRIPTION OF THE DRAWINGS

Fig. 1 is a schematic diagram showing an exemplary composite porous resin base material according to the present invention.
Fig. 2 is a flow diagram showing exemplary steps of manufacturing the composite porous resin base material according to the present invention.
Fig. 3 is an explanatory diagram showing the relation between the height of a functional section, the height of a step and the thickness of a frame plate in the composite porous resin base material according to the present invention.
Fig. 4 is an explanatory diagram showing a method for forming a step by hot pressing.

### DESCRIPTION OF THE REFERENCE SIGNS

1 composite porous resin base material, 2 porous resin film, 3 functional section, 4 electrode (conductive portion), 5 step, 6 frame plate, 7 hole for pinning, 21 porous resin base material, 202 porous resin film, 203 functional section, 204 electrode, 205 step, 206 frame plate, 401 lower mold section, 402 upper mold section, 403 porous resin base material, 404 porous resin base material provided with step.

### BEST MODES FOR CARRYING OUT THE INVENTION

### 1. Porous Resin Film (Base Film):

An anisotropic conductive film for a burn-in test of a semiconductor integrated circuit device or the like is preferably excellent in thermal resistance of a base film. The anisotropic conductive film must be electrically insulative in the lateral direction (perpendicular to the thickness direction). Therefore, synthetic resin forming a base film of the porous resin base material must be electrically insulative.

For example, fluororesin such as polytetrafluoroethylene (PTFE), a tetrafluoroethylene/hexafluoropropylene copolymer (FEP), a tetrafluoroethylene/perfluoroalkyl vinyl ether copolymer (PFA), polyvinylidene fluoride (PVDF), a polyvinylidene fluoride copolymer or an ethylene/tetrafluoroethylene copolymer (ETFE resin); engineering piastic such as polyimide (PI), polyamide imide (PAI), polyamide (PA), modified polyphenylene ether (mPPE), polyphenylene sulfide (PPS), polyether ether ketone (PEEK), polysulfone (PSU), polyether sulfone (PES) or a liquid crystal polymer (LCP); or the like can be listed as the synthetic resin material forming the porous resin film used as the base film.

Among these synthetic resin materials, fluororesin is preferable, and polytetrafluoroethylene (PTFE) is particularly preferable in view of heat resistance, workability, mechanical characteristics, dielectric characteristics and the like.

Perforation, phase separation, solvent extraction, drawing, laser application or the like can be listed as a method for manufacturing the porous resin film of synthetic resin. Among these methods, drawing is preferable in the point that the average pore size and the porosity are easily controlled. The porous resin film is so prepared from synthetic resin that the film can be elastic in the thickness direction while the dielectric constant can be further reduced.

The porous resin film used as the base film of the anisotropic conductive film preferably has porosity of about 20 to 80 %. The porous resin film preferably has an average pore size of not more than 10 µm or a bubble point of at least 2 kPa, and the average pore size is preferably not more than 5 µm, more preferably not more than 1 µm in view of fining the pitch of conductive portions. The lower limit of the average pore size is about 0.05 µm. The bubble point of the porous resin film is preferably at least 5 kPa, more preferably at least 10 kPa. While the upper limit of the bubble point is about 300 kPa, the present invention is not restricted to this.

The thickness of the porous resin film, properly selectable in response to the object of use and the portion of use, is generally 20 to 3000 µm, preferably 25 to 2000 µm, more preferably 30 to 1000 µm. Therefore, the thickness of the porous resin film includes regions of a film (less than 250 µm) and a sheet (at least 250 µm). If the thickness of the porous resin film is too small, it is difficult to form a step having a level difference allowing arrangement of a rigid frame plate.

Among porous resin films, a porous polytetrafluoroethylene film obtained by drawing (drawn porous PTFE film), having excellent heat resistance, workability, mechanical characteristics, dielectric characteristics etc. and facilitating formation of a porous resin film having uniform pore size distribution, is the most excellent material as the base film of the anisotropic conductive film. Further, the drawn porous PTFE film has a fine structure consisting of large numbers of fibrils and nodes, and conductive metal such as plating particles can be bonded to the fibrils.

The drawn porous PTFE film used in the present invention can be manufactured by a method described in Japanese Patent Publication Gazette No. 42-13560, for example. First, a fluid lubricant is mixed into unsintered powder of PTFE, and the mixture is extruded into the form of a tube or a plate by ram extrusion. When a sheet having a small thickness is desired, a platy body is rolled by a pressure roll. After the extrusion/rolling step, the fluid lubricant is removed from the extruded or rolled product if necessary. When the extruded or rolled product obtained in this manner is drawn at least in a uniaxial direction, unsintered drawn porous PTFE is obtained in the form of a film. When the unsintered drawn porous PTFE film is so fixed as not to cause contraction and heated to a temperature of at least 327°C corresponding to the melting point of PTFE so that the drawn structure is sintered/fixed, a drawn porous PTFE film having high strength is obtained. When the drawn porous PTFE film is in the form of a tube, a flat film can be obtained by cutting the tube open.

The drawn porous PTFE film has a fine structure consisting of extremely thin fibrils formed by PTFE and nodes coupled with each other by these fibrils. In the drawn porous PTFE film, this fine structure forms the porous structure.

### 2. Porous Resin Base Material provided with Electrode and/or Circuit:

When the porous resin base material provided with electrodes is used as an anisotropic conductive film, through-holes passing through a first surface and a second surface in the thickness direction are preferably formed on a plurality of portions of the base film consisting of the electrical insulating porous resin film prepared from synthetic resin and conductive metal is preferably bonded to porous resin portions (fibrils, for example) on the inner wall surfaces of the respective through-holes, thereby forming a plurality of conductive portions (cylindrical electrodes) capable of providing conductivity in the thickness direction, independently of each other. The conductive metal can be generally bonded by a method of bonding plating particles to the porous resin portions on the inner wall surfaces of the through-holes by electroless plating or a combination of electroless plating and electroplating.

While the method for providing the plurality of through-holes in the thickness direction of the porous resin film and the method for forming the conductive portions (cylindrical electrodes) on the inner wall surfaces of the through-holes by bonding the conductive metal are not particularly restricted, the following methods can be illustrated, for example.

For example, a method for manufacturing a porous resin base material including the following steps a to e:
(a) the step a of forming a three-layer laminate by stacking resin layers on both surfaces of a porous resin film as mask layers;
(b) the step b of forming a plurality of through-holes in the laminate to pass therethrough in the thickness direction;
(c) the step c of bonding a catalyst facilitating reduction of metallic ions to the surface of the laminate including the inner wall surfaces of the through-holes;
(d) the step d of separating the mask layers from the porous resin film; and
(e) bonding conductive metal to the resin portions on the inner surfaces of the through-holes with the said catalyst;
can be listed.

A resin material is preferably employed as the material for the mask layers. When a porous fluororesin film is employed as the porous resin film, the same type of porous fluororesin films are preferably employed as the mask layers, while nonporous fluororesin films or nonporous or porous resin films consisting of a resin material other than fluororesin can also be employed. In view of the balance between fusibility and separability between the layers, porous resin films of the same type as the porous resin film are preferably employed as the material for the mask layers.

The mask layers are arranged on both surfaces of the porous resin film, and the three layers are integrated with each other generally by fusion. If a drawn porous PTFE film is employed as the porous resin film, the same type of drawn porous PTFE films are preferably employed also as the mask layers. A laminate in which the layers are fused together can be obtained by performing thermocompression bonding on these three layers. This laminate can be easily separated in a later step.

A plurality of through-holes are formed in this laminate in the thickness direction thereof. As a method for forming the through-holes, i) mechanical perforation, ii) etching by optical ablation, iii) a method employing an ultrasonic head having at least one oscillator on the forward end and perforating the laminate by pressing the forward end of the oscillator against the same and applying ultrasonic energy or the like can be listed.

For mechanical perforation, machining such as press working, punching or drilling can be employed. According to machining, through-holes having a relatively large diameter of at least 50 µm, in most cases at least 75 µm, or further at least 100 µm can be formed at a low cost. Through-holes having a smaller diameter can also be formed by machining.

When forming the through-holes by optical ablation, a method for forming patterned through-holes by applying light to the surface of the laminate through a light blocking sheet (mask) having a plurality of light transmission portions (openings) independent of each other in the form of a prescribed pattern is preferably employed. The light is transmitted through the plurality of openings of the light blocking sheet for etching the irradiated portions of the laminate, thereby forming through-holes. Through-holes having a relatively small diameter of 10 to 200 µm, in most cases 15 to 150 µm, and further 20 to 100 µm can be formed according to this method. Synchrotron radiation, a laser beam or the like can be listed as the light applied by optical ablation.

In the ultrasonic method, patterned through-holes are formed by applying ultrasonic energy to the laminate with an ultrasonic head having at least one oscillator on the forward end. Ultrasonic energy is applied to only portions close to that coming into contact with the forward end of the oscillator so that the temperature is locally increased by ultrasonic vibration energy and resin is easily cut and removed for forming through-holes.

In formation of the through-holes, a method impregnating a soluble polymer such as polymethyl methacrylate or paraffin into the porous structure of the porous fluororesin sheet in a solution state or a molten state, solidifying the same and thereafter perforating the sheet can also be employed. According to this method, the porous structure on the inner walls of the through-holes can be preferably easily held. After the perforation, the soluble polymer or paraffin can be dissolved or fused to be removed.

The through-holes may have an arbitrary shape such as a circular, elliptical, starlike, octagonal, hexagonal, quadrangular or triangular shape. The diameter of the through-holes can be reduced generally to 5 to 100 µm, further to 5 to 30 µm in an application field to which small-diametral through-holes are suitable. In a field to which relatively large-diametral through-holes are suitable, on the other hand, the diameter of the through-holes can be increased generally to 50 to 3000 µm, in most cases to 75 to 2000 µm, and further to 100 to 1500 µm. A plurality of through-holes are preferably formed in the form of a prescribed pattern in coincidence of distribution of electrodes of a circuit device such as a semiconductor integrated circuit device or a printed circuit board, for example.

In order to bond the catalyst (also referred to as "plating catalyst") facilitating reduction of metallic ions to the surface of the laminate including the inner wall surfaces of the through-holes, the laminate may be dipped in a palladium-tin colloidal catalytic solution, for example, while sufficiently stirring the solution. Through the catalyst adhering to and remaining on the inner wall surfaces of the through-holes, the conductive metal is selectively bonded to the inner wall surfaces. While electroless plating, sputtering, conductive metal paste coating or the like can be listed as the method for bonding the conductive metal, electroless plating is preferable among these methods.

The catalyst (palladium-tin, for example) remaining on the inner wall surfaces of the through-holes is activated before performing electroless plating. More specifically, the laminate is dipped in organic acid salt or the like commercially available as a product for activating a plating catalyst, thereby dissolving tin and activating the catalyst. The porous resin film provided with the catalyst on the inner wall surfaces of the through-holes is so dipped in the electroless plating solution that the conductive metal (plating particles) can be deposited only on the inner wall surfaces of the through-holes to which the catalyst is bonded. Cylindrical electrodes are formed by this method. While copper, nickel, silver, gold or a nickel alloy can be listed as the conductive metal, copper is preferably used if high conductivity is necessary.

When the drawn porous PTFE film is used, the plating particles are first deposited to intertwine with the resin portions (mainly fibrils) exposed on the inner wall surfaces of the through-holes of the drawn porous PTFE film, whereby the bonding state of the conductive metal can be controlled by controlling the plating time. A proper quantity of plating is so employed that conductive metal layers are formed in a state maintaining the porous structure, whereby conductivity in the thickness direction can also be provided simultaneously with elasticity.

The thickness of the resin portions of the fine porous structure (thickness of the fibrils of the drawn porous PTFE film, for example) is preferably not more than 10 µm, more preferably not more than 5 µm, further preferably not more than 1 µm. The particle diameter of the conductive metal is preferably about 0.001 to 5 µm. The quantity of the bonded conductive metal is preferably set to about 0.01 to 4.0 g/ml, in order to maintain the porous structure and the elasticity.

The conductive portions (cylindrical electrodes) prepared in the above are preferably coated with an antioxidant, or rare metal or an alloy of rare metal, in order to prevent oxidation and improve electrical contact. Palladium, rhodium or gold is preferable as the rare metal, in the point that the same has small electric resistance. The thickness of the coating layers is preferably 0.005 to 0.5 µm, more preferably 0.01 to 0.1 µm. When the conductive portions are coated with gold, for example, a method coating the conductive metal layers with nickel of about 8 nm and thereafter performing immersion gold plating is effective.

When the drawn porous PTFE film is used as the porous resin film, cylindrical electrodes having such a structure that conductive metal particles are bonded to the fibrils on the inner wall surfaces of through-holes are formed. When stress is applied to this porous fluororesin base material in the thickness direction, the distance between the fibrils is so reduced as to relax the stress, and the structure of the cylindrical electrodes is not broken but maintained. Also when compressive force is repetitively applied to the drawn porous PTFE base material, therefore, the cylindrical electrodes are hardly deteriorated.

While the cylindrical electrodes generally have such a structure that the conductive metal is bonded to only the inner wall surfaces of the through-holes provided in the thickness direction of the porous fluororesin film, lid bodies of the conductive metal may be formed by adjusting the quantity of electroless plating or performing electroplating in addition to electroless plating thereby blocking first ones or both of pairs of opening ends of the cylindrical electrodes. When the quantity of plating is increased, plating particles grow from edges of the opening ends, to block orientation ends. On the other hand, there is a method for applying viscose paste containing conductive metal particles to the opening ends, as a method for blocking the opening ends without increasing the quantity of the conductive metal bonded to the inner wall surfaces of the through-holes. When the lid bodies are formed by blocking the opening ends of the cylindrical electrodes with the conductive material by such a method, contact areas between the cylindrical electrodes of the porous fluororesin base material and circuit electrodes and/or electrodes of a semiconductor chip can be increased.

The porous resin base material used in the present invention can be provided with electrodes and/or circuits of various structures, in place of the aforementioned cylindrical electrodes. For example, a method of preparing a substrate by bonding copper foil to the surface of a porous resin film and forming electrodes and/or circuits on the copper foil layer by photolithography can be listed. Further, there is a method of applying a plating catalyst to a porous resin film in the same pattern as the shape of electrodes or circuits and forming the electrodes or the circuits by electroless plating or a combination of electroless plating and electrolytic plating through the plating catalyst.

The porous resin base material, provided with the functional section having the electrodes and/or the circuits, has a portion provided with no electrodes and/or circuits around the functional section, in order to mount the frame plate.

### 3. Frame Plate:

According to the present invention, a frame plate prepared from a material having higher rigidity than the porous resin film constituting the base film of the porous resin base material is preferably employed. A metallic material, a ceramic material, a resin material etc. are typical materials for forming the frame plate.

For example, metal such as copper, nickel, chromium, cobalt, iron, magnesium, manganese, molybdenum, indium, lead, palladium, titanium, tungsten, aluminum, gold, platinum or silver; an alloy such as stainless steel containing at least two types of these metals; or the like can be listed as the metallic material constituting the frame plate.

While polyester, polyamide, fluororesin, various engineering plastics, an elastomer or the like can be listed as the resin material constituting the frame plate, a heat-resistant resin material having a melting point or a glass transition temperature of at least 150°C is preferable among these materials. The melting point and the glass transition point are values measured by a differential scanning calorimeter (DSC).

For example, polybutylene terephthalate, polyethylene terephthalate, nylon 6, nylon 66, nylon 46, polyphenylene sulfide, polyether ether ketone, total aromatic polyester, polymethyl pentene, polytetrafluoroethylene, a tetrafluoroethylene/hexafluoropropylene/perfluoroalkoxy vinyl ether copolymer, a tetrafluoroethylene/hexafluoropropylene copolymer, a tetrafluoroethylene/perfluoroalkyl vinyl ether copolymer, polyphenylene ether, polyallylate, polysulfone, polyether sulfone, polyether imide, polyamide imide, a liquid crystal polymer, thermosetting polyimide, thermoplastic polyimide, cyclic olefin resin or the like can be listed as the heat-resistant resin material constituting the frame plate.

Such a resin material can be compounded with a fibrous filler such as glass fiber, a granular or powder inorganic filler or the like, in order to improve heat resistance and strength. A method for molding the resin material into the shape of the frame plate is not particularly restricted, but injection molding, compression molding, extrusion molding or the like can be arbitrarily selected. The frame plate may be formed by drawing the resin material. Further, the frame plate may be formed by molding the resin material and thereafter cross-linking or curing the same.

The thickness of the frame plate is generally 5 to 1500 µm, preferably 10 to 1000 µm, more preferably 20 to 700 µm. If the thickness of the frame plate is too small, it is difficult to obtain sufficient rigidity and strength depending on the material. If the thickness of the frame plate is too large, it is difficult to handle the composite porous resin base material.

While the frame plate generally has a frame shape provided with an opening, the shape thereof and the shape of the opening can be arbitrarily designed in response to the shapes of the porous resin base material and the functional section. The size of the frame of the frame plate can be arbitrarily designed in response to the shape of the porous resin base material, so far as a reinforcing effect can be attained. However, the frame plate must have portions having a thickness allowing formation of holes for pinning.

### 4. Composite Porous Resin Base Material:

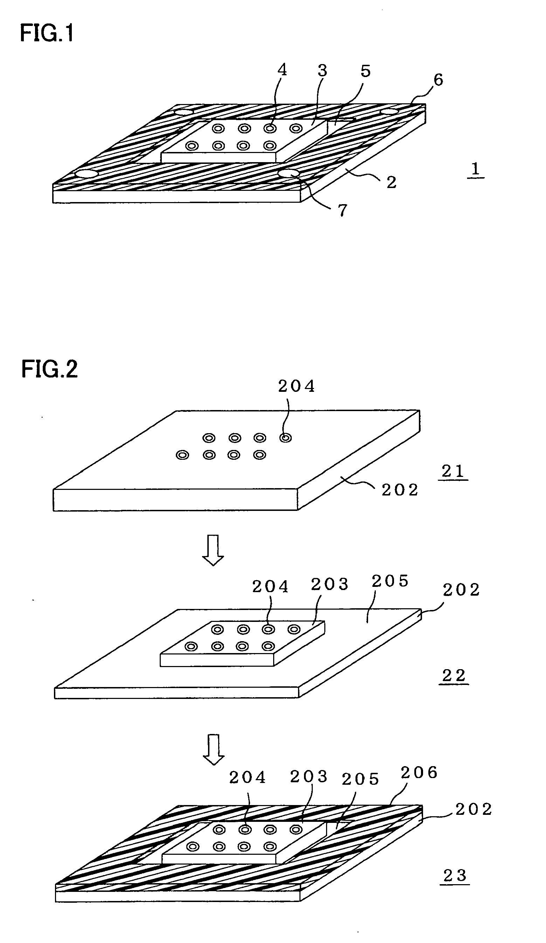

Fig. 1 is a schematic diagram showing an exemplary composite porous resin base material according to the present invention. This composite porous resin base material 1 has a functional section 3 obtained by forming conductive portions (cylindrical electrodes) 4 on a porous resin film 2, and a step 5 having a height smaller than the height of the functional section is formed on the periphery (portion of only the porous resin film) surrounding the functional section. A frame plate 6 having a thickness smaller than the height of the step is arranged on the surface of step 5.

Pinning holes 7 are formed through frame plate 6 and step 5 of the porous resin base material. Pinning holes 7 can be formed by an arbitrary method such as mechanical perforation, optical ablation, perforation with ultrasonic energy or the like. While a frame plate previously provided with pinning holes may be employed, the step of the porous resin base material provided under the same is perforated through the pinning holes of the frame plate in this case.

Fig. 2 is a flow diagram showing exemplary steps of manufacturing a composite porous resin base material. A porous resin base material 21 has a functional section 203 obtained by forming conductive portions (cylindrical electrodes) 204 at the center of a porous resin film 202. A step 205 having a height smaller than the height of functional section 203 is formed on the periphery of porous resin base material 21 surrounding functional section 203 by hot pressing. Then, a frame plate 206 having a thickness smaller than the height of the step is arranged on the surface of step 205, thereby preparing a composite porous resin base material 23.

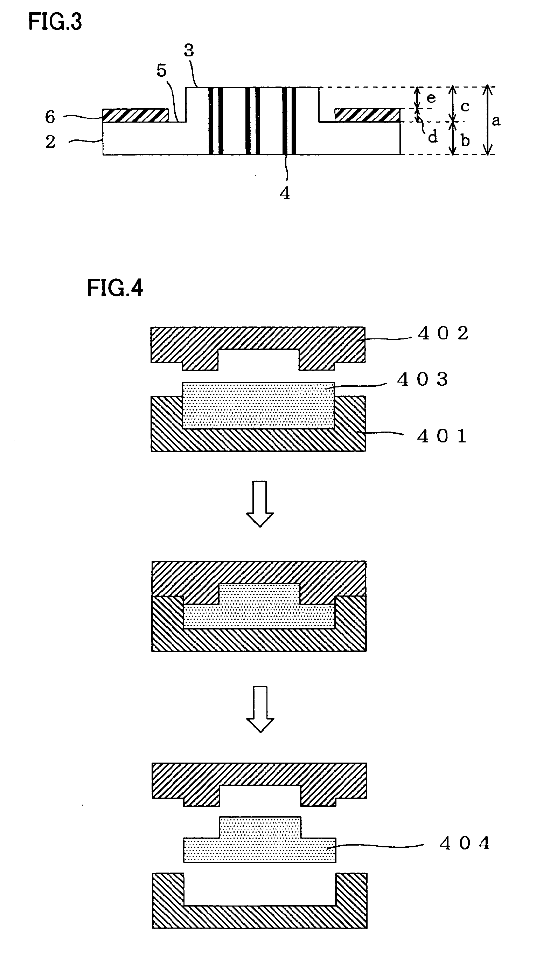

Fig. 3 is a sectional view of the composite porous resin base material. Assuming that a represents the height of functional section 3 of the porous resin base material and b represents the height of step 5, a > b, and c (a - b = c) represents the height of the step. Assuming that d represents the thickness of frame plate 6, c > d, and e (c - d = e) represents the difference between the heights of the upper surfaces of frame plate 6 and functional section 3.

The height b of the step is generally 20 to 90 %, preferably 30 to 80 %, more preferably 40 to 70 % of the thickness a of the porous resin base material. If the height b of the step is too large, the thickness d of the frame plate cannot be sufficiently increased. If the height b of the step is too small, elasticity of the overall porous resin base material may be damaged, or deformation may be caused in hot pressing.

The difference e between the heights of the upper surfaces of functional section 3 and frame plate 6 is generally at least 2 to 500 µm, preferably 3 to 400 µm, more preferably 5 to 300 µm, depending on the thickness of the porous resin base material. If this difference e is too short, elasticity of the functional section may be damaged, or connection with electrodes of a circuit device or the like may be difficult. If this difference e is too long, excess compressive force may be applied to the functional section. Functional section 3 so properly protrudes that conduction with a circuit device or the like can be attained with a low load.

While the method for forming the step is not particularly restricted, hot pressing is preferable. In hot pressing, two mold sections 401 and 402 are used and a porous resin base material 403 is placed in lower mold section 401 as shown in Fig. 4, for example. Upper mold section 402 is hot-pressed to engage with lower mold section 401. The shape and the height of the step can be controlled by adjusting the shape of upper mold section 402. When released from the mold sections after the hot pressing, a porous resin base material 404 having a step can be obtained.

The heating temperature in the hot pressing is at a level less than the thermal decomposition temperature of the resin material constituting the porous resin base material, and can be properly set in response to the type of the resin material. When the base film is a drawn porous fluororesin film such as a drawn PTFE film, the heating temperature is generally 200 to 320°C, preferably 250 to 310°C. The pressure is set to a level under which the upper and lower mold sections mesh with each other. The pressurization time can be properly set in response to the type of the resin material on condition that the shape of the step is fixed. When the base film is a drawn porous fluororesin film such as a drawn PTFE film, the pressurization time is generally 100 to 1000 seconds, preferably sufficient for 200 to 800 seconds, while the present invention is not restricted to this.

In order to form the step, a method other than hot pressing may be employed. While machining such as cutting can be listed as another method, it is generally difficult and inefficient to cut a thin porous resin base material in a correct thickness. While the step can also be formed by optical ablation, it is difficult to efficiently etch a wide region.

The frame plate, which may simply be placed on the step, can be bonded or stuck to the step with an adhesive or a sticking agent. When the frame plate is bonded or stuck to the step, formation of pinholes or positioning in pinning is simplified. When a sticking agent is used, the frame plate can be easily recycled.

A material capable of bonding or sticking and fixing the metallic material, the ceramic material or the resin material constituting the frame plate and the resin material constituting the porous resin base material to each other is preferably selected as the adhesive or the sticking agent.

While a thermoplastic resin-based adhesive such as a polyvinyl acetate-based, polyvinyl alcohol-based, polyvinyl butyral-based, polyvinyl acetal-based, polyolefin-based, polyvinyl chloride-based, polymethyl methacrylate-based, polystyrene-based, polyamide-based, polyisobutyrene-based, hot melt fluororesin-based or modified polyphenylene ether resin-based adhesive; a thermosetting resin-based adhesive such as a urea resin-based, melamine resin-based, phenol resin-based, resorcinol resin-based, epoxy resin-based, polyurethane-based or unsaturated polyester-based adhesive; an elastomer-based adhesive such as a chloroprene rubber-based, nitrile rubber-based, SBR-based, SBS-based, SIS-based, butyl rubber-based, polysulfide-based or silicone rubber-based adhesive or the like can be listed as the adhesive, for example, the present invention is not restricted to these.

This adhesive can be applied to the bonded surface in the form of a solution, an emulsion or a solventless adhesive. The adhesive can be applied to the bonded surface in the form of a film or a sheet (dry film). A hot melt-type adhesive can be heated/melted to be applied to the bonded surface. The bonded surface is the upper surface of the step or the lower surface of the frame plate.

A rubber-based sticking agent, an acrylic-based sticking agent or a silicone-based sticking agent can be listed as the sticking agent. A solvent-type sticking agent such as a natural rubber-based, styrene-butadiene-based, polyisobutyrene-based or isoprene-based sticking agent; a hot melt type sticking agent such as a styrene-isoprene block copolymer, a styrene-butadiene block copolymer, a styrene-ethylene-butyrene block copolymer or an ethylene-vinyl acetate thermoplastic elastomer can be listed as the rubber-based sticking agent. Acrylic-based sticking agents include solvent- and emulsion-type ones. This sticking agent can also be applied by a method for applying the same to a stuck surface or the like, similarly to the adhesive. A double-faced adhesive tape may be placed on the stuck surface, for fixing the step and the frame plate to each other by adhesion.

The composite porous resin base material according to the present invention can be prepared by employing a porous resin base material previously provided with electrodes and/or circuits. If the electrodes and/or the circuits may be damaged by hot pressing at a high temperature, the composite porous resin base material can be prepared by providing a step on a porous resin film (base film), arranging a frame plate on this step and thereafter forming electrodes and/or circuits on a portion (central section) of the porous resin film corresponding to an opening of the frame plate. The composite porous resin base material may alternatively be prepared by providing a step on a porous resin film (base film), forming electrodes and/or circuits on a portion (central section) of the porous resin film corresponding to an opening of a frame plate and thereafter arranging the frame plate.

The method for forming the electrodes and/or the circuits is described above. When employing the said step a of forming the three-layer laminate by stacking the porous resin layers on both surfaces of the porous resin film as mask layers in formation of the electrodes and/or the circuits, a step of previously providing the step on the porous resin film by hot-pressing the laminate and thereafter forming the electrodes and/or the circuits is preferably arranged, in order to avoid defective conduction of the electrodes and/or the circuits resulting from hot pressing at a high temperature.

While the present invention is now more specifically described with reference to Examples, the present invention is not restricted only to these Examples.

### Example 1

Drawn porous PTFE sheets having porosity of 60 %, an average pore size of 0.1 µm and a thickness of 30 µm were superposed on both surfaces of a base film of a drawn porous PTFE film having porosity (ASTM-D-792) of 60 %, an average pore size of 0.1 µm, a bubble point (measured according to ASTM-F-316-76 with isopropyl alcohol) of 150 kPa and a thickness of 600 µm, held between two stainless plates having a thickness of 3 mm, subjected to a load and heat-treated at 350°C for 30 minutes. After the heating, annealing was performed from above the stainless plates with water, thereby obtaining a porous PTFE laminate having a fused three-layer structure.

The laminate obtained in the aforementioned manner was cut into 40 mm square. This sample was hot-pressed (at a heating temperature of 300° for a pressing time of 600 seconds) with the molding die assembly shown in Fig. 4, for forming a step having a level difference of 300 µm and a width of 10 mm on the periphery of the base film.

A drill was worked on a protrusion (portion corresponding to a functional section) of the laminate under conditions of a rotational speed of 100,000/min. and a feed rate of 0.01 mm/rev., for forming through-holes of 250 µmφ in diameter on a plurality of portions at a pitch of 1 mm. The laminate provided with the through-holes was dipped in ethanol for one minute to be rendered hydrophilic, and thereafter dipped in Melplate PC-321 by Meltex Inc. diluted to 100 ml/L at a temperature of 60°C for 4 minutes, to be degreased. Further, the laminate was dipped in sulfuric acid of 10 % for 1 minute, and thereafter dipped in a solution prepared by dissolving Emplate PC-236 by Meltex Inc. in hydrochloric acid of 0.8 % at a ratio of 180 g/L for 2 minutes as predipping.

Further, the laminate was dipped in a solution prepared by dissolving Emplate PC-236 by Meltex Inc. in an aqueous solution obtained by dissolving 3 % of Emplate Activator 444 by Meltex Inc., 1 % of Emplate Activator Additive and 3 % of hydrochloric acid at a ratio of 150 g/L for 5 minutes, for bonding catalytic particles to the surface of the laminate and the wall surfaces of the through-holes. Then, the laminate was dipped in a 5 % solution of Emplate PA-360 by Meltex Inc. for 5 minutes, for activating palladium catalytic nuclei. Thereafter the mask layers forming the first and third layers were separated, thereby obtaining a porous PTFE film in which catalytic palladium particles were bonded only to the inner wall surfaces of the through-holes.

The aforementioned PTFE film was dipped in an electroless copper plating solution made up of 5 % of Melplate Cu-3000A by Meltex Inc., 5 % of Melplate Cu-3000B, 5 % of Melplate Cu-3000C and 5 % of Melplate Cu-3000D and 0.1 % of Melplate Cu-3000 Stabilizer with sufficient air agitation, for rendering only the wall surfaces of the through holes of 250 µmφ conductive with copper particles.

Then, gold plating was performed in order to attain rust prevention and to improve contactability with circuit board electrodes. Immersion gold plating from nickel was employed as the gold plating by the following method: The porous PTFE film having the copper particles bonded to the inner wall surfaces of the through-holes was dipped in Activator Aurotec SIT Additive (80 ml/L) by Atotech Japan for 3 minutes as predipping, dipped in an electrolytic bath of Aurotec SIT Activator Conc (125 ml/L) by Atotech Japan and Activator Aurotec SIT Additive (80 ml/L) by Atotech Japan for 1 minute as catalyzation, and further dipped in Aurotec SIT Postdip (25 ml/L) by Atotech Japan for 1 minute, for bonding the catalyst to the copper particles.

Then, the base film was dipped in an electroless nickel plating solution made up of sodium hypophosphate (20 g/L), trisodium citrate (40 g/L), ammonium borate (13 g/L) and nickel sulfate (22 g/L) for 5 minutes, for coating the copper particles with nickel. Thereafter the base film was dipped in an immersion gold plating solution by Meltex Inc. [Melplate AU-6630A (200 ml/L), Melplate AU-6630B (100 ml/L), Melplate AU-6630C (20 ml/L), an aqueous solution of gold sodium sulfate (1.0 g/L as gold)] for 5 minutes, for coating conductive particles with gold.

An acrylic sticking agent was applied to a single surface of a stainless steel frame plate (vertical and horizontal length = 40 mm, size of opening = 25 mm by 25 mm, thickness = 100 µm), and the frame plate was stuck to the step of the drawn porous PTFE base material. Thereafter holes of 1000 µm in diameter were provided on the four corners of the frame plate through the lower layer by drilling.

It has been confirmed that the composite drawn porous PTFE base material obtained in this manner conducted conductive when a load was applied to the functional section, and was elastically recovered when the load was removed. This composite drawn porous PTFE base material was fixed to an electrode region of a testing device by pinning while adjusting the positional relation so that respective electrodes of this testing device and the respective conductive portions (cylindrical electrodes) were connected with each other. While an electric test of a semiconductor chip was repeated 100 times, the drawn porous PTFE base material was not deformed, and no breakage from the pinned portions was recognized.

### INDUSTRIAL APPLICABILITY

The composite porous resin base material according to the present invention can be preferably used as an anisotropic conductive film employed for electrically connecting two circuit devices with each other or an anisotropic conductive film employed for electrically testing a circuit device such as a semiconductor integrated circuit device or a printed circuit board, for example.

## Claims

1. A composite porous resin base material (1) comprising a porous resin film (2) having a functional section (3) provided with an electrode (4) and/or a circuit, a step (5), having a height different from the height of said functional section, formed on the periphery surrounding said functional section (3) and a frame plate (6) arranged on the surface of said step.

2. The composite porous resin base material (1) according to claim 1, wherein
the height of said step (5) is smaller than the height of said functional section (3).

3. The composite porous resin base material (1) according to claim 2, wherein
the thickness of said frame plate (6) is smaller than the height of the step.

4. The composite porous resin base material (1) according to claim 1, wherein
said porous resin film (2) is a porous fluororesin film obtained by providing a functional section provided with an electrode and/or a circuit on a porous fluororesin film.

5. The composite porous resin base material (1) according to claim 4, wherein
said porous fluororesin film is an anisotropic conductive film having a plurality of through-holes provided in the thickness direction of the porous fluororesin film and cylindrical electrodes formed on the inner wall surfaces of said through-holes by bonding conductive metal.

6. A method for manufacturing a composite porous resin base material (23), including the following steps 1 and 2:
(1) the step 1 of forming a step (205) having a height smaller than the height of a functional section (203) on the periphery surrounding said functional section (203) of a porous resin base material (21) having said functional section (203) provided with an electrode (204) and/or a circuit; and
(2) the step 2 of arranging a frame plate (206) having a thickness smaller than the height of the step on the surface of said step (205).

7. A method for manufacturing a composite porous resin base material, including the following steps A to C:
(A) the step A of forming a step having a height smaller than the height of a central section on the periphery surrounding said central section of a porous resin film;
(B) the step B of arranging a frame plate having a thickness smaller than the height of the step on the surface of said step; and
(C) the step C of forming an electrode and/or a circuit on said central section of the porous resin film.

8. A method for manufacturing a composite porous resin base material, including the following steps I to III:
(I) the step I of forming a step having a height smaller than the height of a central section on the periphery surrounding said central section of a porous resin film;
(II) the step II of forming an electrode and/or a circuit on said central section of the porous resin film; and
(III) the step III of arranging a frame plate having a thickness smaller than the height of the step on the surface of said step.
